Europäisches Patentamt

European Patent Office

Office européen des brevets

(11) Veröffentlichungsnummer: **0 262 485**
A1

(12) # EUROPÄISCHE PATENTANMELDUNG

(21) Anmeldenummer: 87113230.4

(22) Anmeldetag: 10.09.87

(51) Int. Cl.⁴: **H01L 29/08** , H01L 29/06 , H01L 29/74 , H01L 29/72 , H01L 29/90

Die Bezeichnung der Erfindung wurde geändert (Richtlinien für die Prüfung im EPA, A-III, 7.3).

(30) Priorität: 01.10.86 CH 3919/86

(43) Veröffentlichungstag der Anmeldung:
06.04.88 Patentblatt 88/14

(84) Benannte Vertragsstaaten:
CH DE FR GB IT LI NL SE

(71) Anmelder: BBC Brown Boveri AG

CH-5401 Baden(CH)

(72) Erfinder: Abbas, C. Christiaan, Dr.
Im Eichtal 2
CH-5400 Baden(CH)
Erfinder: Gobrecht, Jens, Dr.
Brühlstrasse 37
CH-5412 Gebenstorf(CH)
Erfinder: Grüning, Horst, Dr.
Im Ergel 10
CH-5404 Baden(CH)
Erfinder: Voboril, Jan
Landschreiberstrasse 2
CH-5415 Nussbaumen(CH)

(54) **Halbleiterbauelement mit einer Ätzgrube.**

(57) Bei einem Halbleiterbauelement, welches innerhalb eines Halbleitersubstrats verschiedene unterschiedlich dotierte Schichten (2, 3, 4, 5) aufweist, wird eine Verbesserung der elektrischen Eigenschaften dadurch erzielt, dass die Dicke des Substrats im stromführenden Bereich lokal durch eine tiefe Aetzgrube (10) reduziert wird, wobei die ursprüngliche mechanische Stabilität des Halbleitersubstrats weitgehend erhalten bleibt.

FIG.4

EP 0 262 485 A1

## Halbleiterbauelement

### Technisches Gebiet

Die vorliegende Erfindung bezieht sich auf ein Halbleiterbauelement. Sie betrifft insbesondere ein Halbleiterbauelement mit einem grossflächigen Halbleitersubstrat, welches zwischen gegenüberliegenden Elektroden eine Mehrzahl von unterschiedlich dotierten Schichten aufweist.

### Stand der Technik

Halbleiterbauelemente in Form von Dioden oder Thyristoren, aber auch MOSFETs oder Hochstromtransistoren, insbesondere für hohe Leistungen, erobern immer grössere Gebiete der Energieerzeugung,-verteilung und der Antriebstechnik.

Neue Möglichkeiten werden dabei durch abschaltbare Thyristoren eröffnet, wie sie als GTO (Gate Turn Off)-Thyristoren oder feldgesteuerte Thyristoren (FCTh = Field Controlled Thyristor) beispielsweise aus der EP-A1 0121068 bekannt sind.

Simulationsrechnungen haben nun gezeigt, dass eine wesentliche Verbesserung des ON-Widerstandes (d.h. des Widerstandes im Durchlasszustand), der Abschaltzeiten und des soge nannten "Tail"-Verhaltens (d.h. des Abklingverhaltens des Stromes beim "snubberless"-Abschalten) für solche GTOs und FCThs erreicht werden kann, wenn die entsprechenden Halbleitersubstrate mit einer Stoppschicht und einer verminderten Dicke der n-Basisschicht ausgeführt werden.

Verringerungen der n-Basisschicht-Dicke in einem für die elektrischen Eigenschaften des Bauelements wirkungsvollen Umfang lassen sich bei Anwendung der herkömmlichen Technologie jedoch nicht erreichen, da die grossflächigen Halbleitersubstrate mit ihren Durchmessern von mehreren Zoll dann viel zu zerbrechlich wären, um bei der Bauelemente-Herstellung sicher gehandhabt zu werden.

Auch die Verwendung von epitaxial aufgewachsenen sogenannten EPI-Schichten wäre keine Lösung, da diese EPI-Schichten zugleich die zusätzliche Dicke für die erhabenen Kathodenfinger beinhalten müssten, und EPI-Schichten mit einer dafür erforderlichen Gesamtdicke von mehr als 100 $\mu$m entweder nicht in der geforderten Qualität herstellbar oder aber zumindest unwirtschaftlich teuer wären.

### Darstellung der Erfindung

Aufgabe der Erfindung ist es daher, ein Halbleiterbauelement zu schaffen, bei dem die Vorteile der Dickenreduktion erreicht werden, ohne die mechanische Stabilität des Halbleitersubstrats zu beeinträchtigen oder zu unwirtschaftlichen Herstellungsverfahren Zuflucht nehmen zu müssen.

Die Aufgabe wird bei einem Halbleiterbauelement der eingangs genannten Art dadurch gelöst, dass zur Verbesserung der elektrischen Eigenschaften die Dicke des Halbleitersubstrats in dem stromführenden Bereich durch eine wenigstens auf einer Seite des Halbleitersubstrats eingebrachte, tiefe Aetzgrube reduziert ist.

Der Kern der Erfindung besteht also darin, durch Einbringen von Aetzgruben in das Halbleitersubstrat von einer oder beiden Seiten nur lokal die Dicke zu reduzieren, so dass um die Aetzgrube herum stegartig die ursprüngliche Substratdicke erhalten bleibt und eine ausreichende mechanische Stabilität gewährleistet.

Bevorzugt wird die Erfindung bei Halbleiterbauelementen verwirklicht, bei denen das Halbleitersubstrat die zwischen einer Anode und einer Kathode angeordnete Schichtenfolge eines GTO oder FCTh aufweist und auf der Kathodenseite eine stufig ausgebildete Gate-Kathoden-Struktur besitzt, bei der eine Mehrzahl von Kathodenfingern aus einer tieferliegenden Gateebene herausragen und mit den dazwischenliegenden Gatebereichen eine Steuerstruktur bilden. Hier ist die Aetzgrube auf der Anodenseite gegenüber der Steuerstruktur angeordnet.

Weitere bevorzugte Ausführungsbeispiele ergeben sich aus den Unteransprüchen.

### Kurze Beschreibung der Zeichnung

Nachfolgend soll die Erfindung unter Bezugnahme auf die Zeichnung anhand von Ausführungsbeispielen beschrieben und näher erläutert werden. Es zeigen:

Fig.1 einen abschaltbaren Thyristor (GTO oder FCTh) mit stufenartiger Gate-Kathoden-Struktur nach dem Stand der Technik in perspektivischer Aussenansicht;

Fig.2 den Thyristor nach Fig.1 (hier speziell als GTO) im Querschnitt entlang der durch die Linie A-A in Fig.1 angedeuteten Ebene;

Fig.3 Ergebnisse von Simulationsrechnungen für den Stromverlauf im Abschaltfall eines Modell-GTO mit unterschiedlich dicker Basisschicht;

Fig.4 den GTO aus Fig.2 mit anodenseitiger Aetzgrube gemäss einem bevorzugten Ausführungsbeispiel der Erfindung;

Fig.5A die Draufsicht auf die Kathodenseite eines fertig strukturierten und passivierten Prototyps eines abschaltbaren Thyristors mit einer Vielzahl paralleler Kathodenfinger;

Fig.5B die Draufsicht auf die Anodenseite eines Thyristors nach Fig.5A mit den der Steuerstruktur gegenüberliegenden Aetzgruben; und

Fig.6 den Querschnitt durch einen abschaltbaren Thyristor mit einer in mehrere Steuerzonen unterteilten Steuerstruktur gemäss einem weiteren bevorzugten Ausführungsbeispiel der Erfindung.

## Wege zur Ausführung der Erfindung

Obwohl die Erfindung nicht darauf beschränkt ist, soll sie nachfolgend speziell im Zusammenhang mit abschaltbaren Thyristoren vom Typ des FCTh oder GTO beschrieben und erläutert werden.

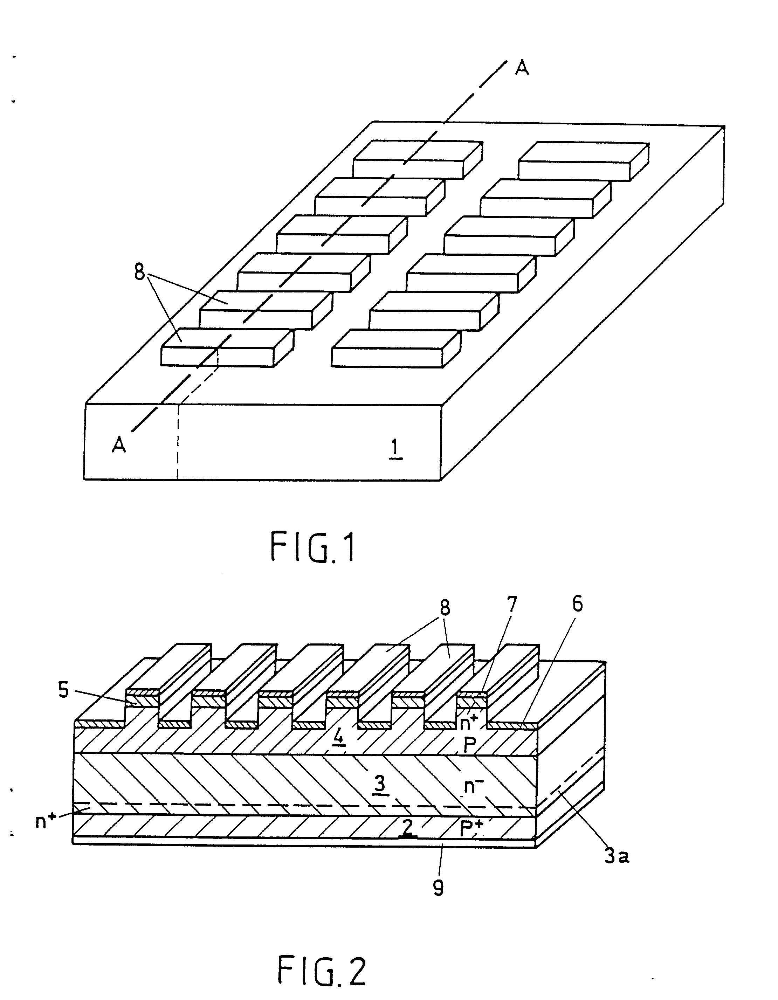

Fig.1 zeigt in perspektivischer Aussenansicht einen solchen abschaltbaren Thyristor mit stufenartiger GateKathoden-Struktur, wie er aus der eingangs erwähnten EP-A + 0 121 068 bekannt ist.

Der bekannte Thyristor umfasst im wesentlichen ein grossflächiges Halbleitersubstrat 1 mit in der Figur nicht dargestellten unterschiedlich dotierten Schichten zwischen einer Anode und einer Kathode.

Auf der Kathodenseite (Oberseite in Fig.1) sind beispielhaft zwei Reihen zu je 6 parallelen Kathodenfingern 8 zu sehen, die über die tieferliegende, sie umgebende Gateebene hinausragen. Die Kathodenfinger 8 bilden zusammen mit den dazwischenliegenden Gatebereichen eine Steuerstruktur, mit deren Hilfe der Stromfluss durch den Thyristor an-bzw. abgeschaltet werden kann. Es versteht sich dabei von selbst, dass der Stromfluss im wesentlichen auf den Bereich des Halbleitersubstrats 1 begrenzt ist, der durch die Kathodenfinger 8 festgelegt wird.

Die Art der Schichtenfolge im Inneren des Halbleitersubstrats 1 hängt davon ab, ob es sich um einen GTO-oder einen FCTh-Typ handelt. Nachfolgend soll zur Erklärung beispielhaft der GTO-Typ herangezogen werden. Dazu ist in Fig.2 das Bauelement aus Fig.1 in einem Querschnitt längs der Ebene wiedergegeben, die in der Fig.1 durch die Linie A-A angedeutet ist.

Man erkennt in Fig.2, dass zwischen einer metallischen Anode 9 und einer metallischen Kathode 7, die entsprechend den Kathodenfingern 8 in einzelne Bereiche zerfällt, eine $p^+$-dotierte Anodenschicht 2, eine $n^-$-dotierte n-Basisschicht 3, eine p-dotierte p-Basisschicht 4, und in den Kathodenfingern 8 jeweils eine $n^+$-dotierte Kathodenschicht 5 übereinander angeordnet sind. Die p-Basisschicht 4 ist auf der tieferliegenden Gateebene durch einen metallischen Gatekontakt 6 kontaktiert, der die Kathodenfinger umgibt und zur Steuerung des Bauelements dient.

Die Funktion dieses GTO ist in der zitierten Druckschrift beschrieben.

Zwischen der n-Basisschicht 3 und der Anodenschicht 2 kann zur Verbesserung der elektrischen Eigenschaften in an sich bekannter Weise zusätzlich eine $n^+$-dotierte Stoppschicht 3a vorgesehen sein, die in der Fig.2 gestrichelt eingezeichnet ist.

Wie bereits erwähnt, sind für ein Bauelement nach Fig.2 mit einem geeigneten Programm Simulationsrechnungen des Abschaltverhaltens durchgeführt worden, bei denen als Parameter bei vorgegebener, konstanter Summe der Dicken von n-Basisschicht 3 und Stoppschicht 3a die Dicke der Stoppschicht 3a variiert wurde.

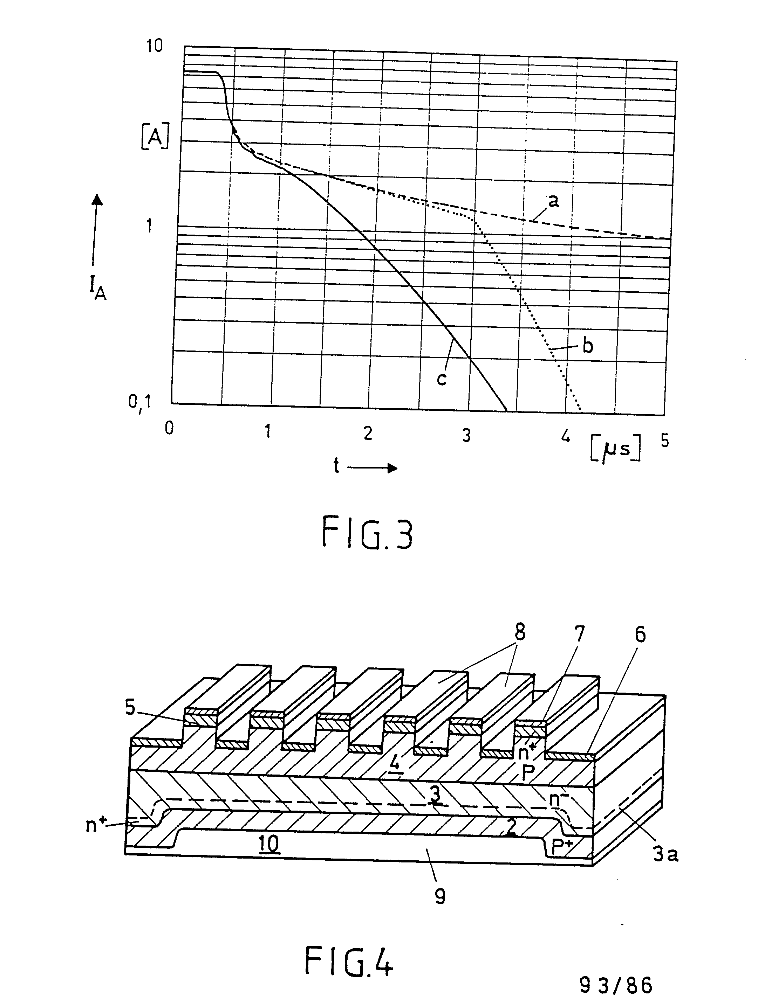

Die Ergebnisse dieser Simulationsrechnungen sind in Fig.3 wiedergegeben als Verläufe des Anodenstroms $I_A$ in Abhängigkeit von der Zeit t beim Abschalten des GTO. Ausgegangen wurde dabei von einem Durchlassstrom von 7,3 A und einer Anodenspannung von 1600 V. Für die drei verschiedenen Kurven a, b und c wurden die folgenden Stoppschicht-Dicken gewählt:

Kurve a:   10 um
Kurve b:   30 um
Kurve c:   90 um

Wegen der konstanten Dickensumme entspricht die Zunahme in der Dicke der Stoppschicht 3a einer entsprechenden Abnahme in der Dicke der n-Basisschicht 3.

Aus Fig.3 erkennt man nun deutlich, dass mit abnehmender Dicke der n-Basisschicht 3 der Anodenstrom nach dem Abschalten zunehmend - schneller abfällt. Während die entsprechende Abfallzeit $T_f$ bei Kurve a grösser als 5 us ist, verringert sie sich bei Kurve b auf 2,9 us, bei Kurve c - schliesslich auf 1,7 $\mu$s, was einer Verkürzung um einen Faktor von mehr als 3 entspricht.

Bereits hieraus wird deutlich, dass eine Verringerung der entsprechenden Schichtdicke zu wesentlichen Verbesserungen in den elektrischen Eigenschaften des Bauelements führt.

Die für die Simulationsrechnungen gemachte Annahme einer konstanten Summe der Dicken von n-Basisschicht 3 und Stoppschicht 3a ist eine künstliche Einschränkung, die auf den Besonderheiten des zugrundeliegenden Modells beruht.

Tatsächlich lassen sich die elektrischen Eigenschaften eines GTO oder FCTh dadurch verbessern, dass bei gleichbleibender Dicke der Stoppschicht die n-Basisschicht und damit das Halbleitersubstrat insgesamt dünner gemacht werden. Aus dem Bauelement nach Fig.2 wird dann ein Bauelement wie es im Querschnitt in Fig.4 dargestellt ist.

Kathodenseitig, beim Aufbau der Kathodenfinger 8, bei den Kathodenschichten 5 und der p-Basisschicht 4 ist gegenüber dem herkömmlichen Bauelement aus Fig.2 keine Aenderung eingetreten.

Dagegen ist in dem neuartigen GTO der Fig.4 die n-Basisschicht 3 im Bereich der die Steuerstruktur bildenden Kathodenfinger 8 dünner ausgelegt, während die Dicken der Stoppschicht 3a und der Anodenschicht 2 sich gegenüber Fig.2 praktisch nicht verändert haben.

Erreicht wird die lokale Dickenreduktion durch Einbringung einer tiefen Aetzgrube 10 in das Halbleitersubstrat von der Anodenseite aus. Diese Aetzung kann beispielsweise mittels des bekannten Verfahrens der reaktiven Ionenätzung (RIE = Reactive Ion Etching) oder durch ein geeignetes nasschemisches Verfahren (z.B. Rollätzen) durchgeführt werden. Wichtig ist dabei, dass die Aetzung mit der notwendigen Gleichmässigkeit erfolgt, um nicht tolerierbare Dickevariationen zu vermeiden. Auch ist es mechanisch und elektrisch günstig, wenn die Aetzgrube 10 am Boden abgerundete Kanten aufweist.

Die Aetzung findet zweckmässigerweise am n-dotierten Ausgangssubstrat statt, sodass anschliessend die Stoppschicht 3a und die Anodenschicht 2 eindiffundiert werden können.

Wesentlich für die mechanische Stabilität des Substrats ist es, dass die Aetzung in Form der Aetzgrube 10 nur lokal in den Bereichen erfolgt, die der Steuerstruktur gegenüberliegen. Auf diese Weise bleiben stegartige Ränder mit der ursprünglichen Dicke bestehen, die einen mechanisch stabilen Rahmen um die Aetzgrube 10 herum bilden.

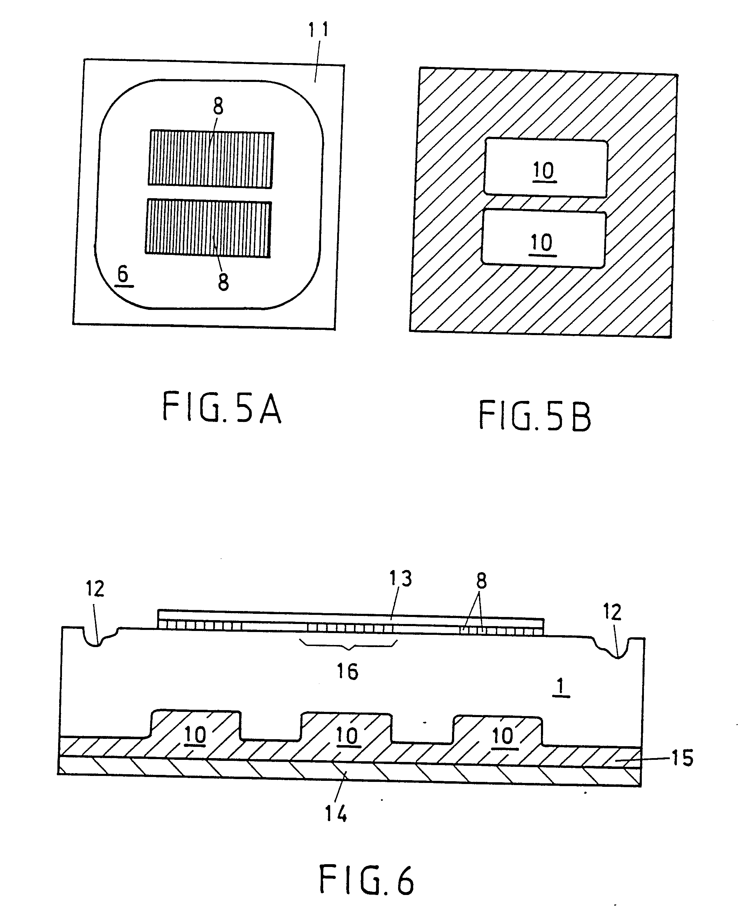

Besonders deutlich wird dies an den Abbildungen der Fig. 5A und 5B, die einen Prototyp eines GTO von der Kathoden-und Anodenseite (Fig.5A bzw. 5B) gesehen zeigen. In Fig.5A ist deutlich die kathodenseitige Steuerstruktur aus zweimal etwa 40 Kathodenfingern zu erkennen, die vom Gatekontakt 6 umgeben sind. Am Rande des Bauelements ist mit seiner Randkontur eine Passivierung 11 angedeutet.

Von der Anodenseite her gesehen (Fig.5B) sind direkt gegenüber der Steuerstruktur zwei entsprechend ausgedehnte Aetzgruben 10 vorgesehen, die eine Dickenreduktion im stromführenden Teil des Bauelements bewirken. Die Aetzgruben 10 sind hier vollständig von den schraffiert eingezeichneten Bereichen ursprünglicher Dicke umgeben.

Die mechanische Stabilität wird weiter erhöht, wenn, wie in Fig.4 zu sehen, die Metallisierung bei der Anode 9 die Aetzgrube 10 vollständig auffüllt, sodass die Dickenreduktion, vom mechanischen Standpunkt aus gesehen, wieder rückgängig gemacht wird. Dies geschieht beispielsweise dadurch, dass die Gruben beim löten des Halbleitersubstrats auf eine Unterlage mit Lot ausgefüllt werden.

Eine andere Massnahme zu Verbesserung der mechanischen Stabilität kann anhand der Fig.6 erläutert werden: Bei Bauelementen für grössere Ströme (z.B.100 A) kann die kathodenseitige Steuerstruktur in einzelne Steuerzonen 16 (ausgelegt z.B. für jeweils 10A) unterteilt werden, die voneinander getrennt sind. Entsprechend können dann auf der Anodenseite grössere Aetzgruben in kleinere unterteilt werden, sodass zwischen den kleineren Aetzgruben 10 neue mechanisch stabile Stege entstehen.

Gezeigt ist in Fig.6 weiterhin eine die Aetzgruben 10 auffüllende Lotschicht 15, mit der das Halbleitersubstrat 1 lunkerfrei auf ein Metallsubstrat 14 gelötet ist.

Im Bauelement nach Fig.6 sind auch die Randgräben 12 angedeutet, die im Fall der häufig verwendeten "moat"-Randabschlusstechnik im Randbereich erforderlich sind. Hier wird ein besonderer Vorteil der Erfindung deutlich: Weil die Dickenreduktion mit den Aetzgruben 10 den Randbereich ausspart, d.h. bei seiner ursprünglichen Dicke belässt, ergeben sich bezüglich des Randbereiches im Hinblick auf die Sperrfähigkeit keine zusätzlichen Probleme.

Schliesslich ist in Fig.6 noch ein Kathodenkontakt 13 dargestellt, mit dem die Kathodenfinger 8 in den einzelnen Steuerzonen 16 kontaktiert werden.

Bei Halbleiterbauelementen der herkömmlichen Art für Sperrspannungen zwischen 1,2 kV und 3 kV wurden bisher Dicken der n-Basisschicht von etwa 200-250 μm erreicht. Nach der vorliegenden Erfindung wird nun die Dicke der n-Basisschicht im Bereich der Aetzgruben auf Werte kleiner 200 μm, vorzugsweise auf Werte zwischen 80 und 150 μm reduziert. Hiermit werden kürzere Schaltzeiten und verringerte Durchlassverluste erreicht.

Die am Beispiel des GTO bzw. FCTh beschriebene erfindungsgemässe Technologie der tiefgeätzten Anode bringt nicht nur bei diesen sondern auch bei anderen Halbleiterbauelementen Vorteile: So lassen sich geringere Durchlassverluste aufgrund einer geringeren Dicke des Siliziumsubstrats auch bei Dioden und Transistoren mit im wesentlichen axial verlaufendem Stromfluss erzielen. Gleichzeitig ergibt sich daraus die Möglichkeit, MOSFETs und Transistoren mit höherer Sperrspannung als etwa 1000 V zu fertigen.

Besonders bei den Dioden kann es dabei auch zweckmässig sein, statt der Anode die Kathode, oder aber beide Seiten, tiefzuätzen.

Insgesamt werden also mit der Erfindung auf einfache Weise Halbleiterbauelemente verschiedenster Art mit deutlich verbesserten elektrischen Eigenschaften zur Verfügung gestellt.

**Ansprüche**

1. Halbleiterbauelement mit einem grossflächigen Halbleitersubstrat (1), welches zwischen gegenüberliegenden Elektroden eine Mehrzahl von unterschiedlich dotierten Schichten aufweist, dadurch gekennzeichnet, dass zur Verbesserung der elektrischen Eigenschaften die Dicke des Halbleitersubstrats (1) in dem stromführenden Bereich durch eine wenigstens auf einer Seite des Halbleitersubstrats (1) eingebrachte, tiefe Aetzgrube (10) reduziert ist.

2. Halbleiterbauelement nach Anspruch 1, dadurch gekennzeichnet, dass

(a) das Halbleitersubstrat (1) die Schichtenfolge eines über das Gate abschaltbaren Thyristors (GTO = Gate Turn Off) oder eines feldgesteuerten Thyristors (FCTh = Field Controlled Thyristor) aufweist, welche Schichtenfolge zwischen einer Anode und einer Kathode angeordnet ist,

(b) das Halbleitersubstrat (1) auf der Kathodenseite eine stufig ausgebildete Gate-Kathoden-Struktur aufweist, bei der eine Mehrzahl von Kathodenfingern (8) aus einer tieferliegenden Gateebene herausragen, und mit den dazwischenliegenden Gatebereichen eine Steuerstruktur bilden; und

(c) die Aetzgrube (10) auf der Anodenseite gegenüber der Steuerstruktur angeordnet ist.

3. Halbleiterbauelement nach Anspruch 2, dadurch gekennzeichnet, dass in dem Halbleitersubstrat (1) anodenseitig eine p-dotierte Anodenschicht (2) und eine darüberliegende schwach n-dotierte n-Basisschicht (3) angeordnet sind, und die Reduzierung der Dicke des Halbleitersubstrats (1) im Bereich der Aetzgrube (10) im wesentlichen zu Lasten der Dicke der n-Basisschicht (3) erfolgt.

4. Halbleiterbauelement nach Anspruch 3, dadurch gekennzeichnet, dass zwischen der Anodenschicht (2) und der n-Basisschicht (3) eine stark n-dotierte Stoppschicht (3a) vorgesehen ist.

5. Halbleiterbauelement nach Anspruch 3, dadurch gekennzeichnet, dass die Dicke der n-Basisschicht (3) im Bereich der Aetzgrube (10) kleiner als 200 um ist und vorzugsweise im Bereich zwischen 80 und 150 um liegt.

6. Halbleiterbauelement nach Anspruch 2, dadurch gekennzeichnet, dass die Steuerstruktur in mehrere voneinander getrennte Steuerzonen (16) unterteilt ist und gegenüber jeder Steuerzone (16) eine Aetzgrube (10) annähernd gleicher Fläche angeordnet ist.

7. Halbleitersubstrat nach Anspruch 2, dadurch gekennzeichnet, dass das Halbleitersubstrat (1) anodenseitig auf ein Metallsubstrat (14) aufgelötet ist und die Aetzgrube (10) vollständig mit Lot ausgefüllt ist.

FIG.1

FIG.2

FIG.3

FIG.4

FIG.5A

FIG.5B

FIG.6

93/86

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| X | EP-A-0 082 419 (SIEMENS AG) * Seite 3, Zeile 20 - Seite 5, Zeile 31; Seite 6, Zeilen 23-25; Figuren 1,5 * | 1 | H 01 L 29/08 H 01 L 29/06 H 01 L 29/74 |
| Y | --- | 2-7 | H 01 L 29/72 H 01 L 29/90 |
| D,Y | EP-A-0 121 068 (BBC AG BROWN, BOVERIE & CIE) * Insgesamt * | 2-7 | |
| | --- | | |
| X | US-A-3 769 563 (KRISHNA et al.) * Spalte 7, Zeilen 39-43; Spalte 8, Zeilen 26-40; Spalte 9, Zeilen 35-39; Figuren 8,12 * | 1 | |
| A | --- | 5,7 | |
| A | EP-A-0 066 721 (HITACHI LTD) * Figur 8 * | 4 | |
| | --- | | |
| A | EP-A-0 029 932 (GENERAL ELECTRIC CO.) * Figuren 2A-2D * | 4 | |
| | --- | | RECHERCHIERTE SACHGEBIETE (Int. Cl.4) |
| A | EP-A-0 064 231 (TOKYO SHIBAURA DENKI K.K.) * Figuren 2,3 * | 6 | H 01 L |
| | --- | | |
| X | PATENT ABSTRACTS OF JAPAN, Band 5, Nr. 141 (E-73) [813], 5. September 1981; & JP-A-56 76 568 (MITSUBISHI DENKI K.K.) 24-06-1981 * Zusammenfassung; Figuren 5,6 * | 1 | |
| A | --- | 2-7 | |
| | --- | | |
| X | US-A-3 553 536 (NEILSON) * Spalte 7, Zeilen 1-43; Figur 11 * | 1 | |
| | ----- | | |

Der vorliegende Recherchenbericht wurde für alle Patentansprüche erstellt

| Recherchenort | Abschlußdatum der Recherche | Prüfer |
|---|---|---|
| DEN HAAG | 08-12-1987 | MORVAN D.L.D. |